Europäisches Patentamt

**European Patent Office**

Office européen des brevets

(19)

(11) Numéro de publication: **0 023 162**

**A1**

(12) ## DEMANDE DE BREVET EUROPEEN

(21) Numéro de dépôt: **80400909.0**

(51) Int. Cl.³: **H 03 H 9/50**

(22) Date de dépôt: **19.06.80**

(30) Priorité: **18.07.79 FR 7918570**

(43) Date de publication de la demande:
**28.01.81 Bulletin 81/4**

(84) Etats Contractants Désignés:
**CH DE GB LI NL SE**

(71) Demandeur: **LIGNES TELEGRAPHIQUES ET
TELEPHONIQUES Société anonyme
1 Rue Charles Bourseul
F-78702 Conflans-Ste Honorine(FR)**

(72) Inventeur: **Ernyei, Herbert
"THOMSON-CSF SCPI 173, bld Haussmann
F-75360 Paris Cedex 08(FR)**

(74) Mandataire: **Benoit, Monique et al,
"THOMSON-CSF" - SCPI 173, bld Haussmann
F-75360 Paris Cedex 08(FR)**

(54) **Perfectionnements aux filtres électromécaniques passe-bande.**

(57) Le filtre est composé de cellules élémentaires.

Chaque cellule élémentaire comporte deux résonateurs (2, 3) vibrant longitudinalement et un coupleur (11) vibrant en flexion connecté entre les deux résonateurs; la cellule de rang i est dimensionnée de telle sorte que l'une des fréquences relative limites ($\Omega^L_i$) de sa bande de fréquences ($\Omega^0_i - \Omega^+_i$) est liée à la fréquence limite (f'$_i$) d'une cellule pour un filtre électrique passe-bas correspondant au filtre électromécanique à réaliser, par la relation:

$$f^+_i = \frac{A}{\sin\alpha ci + \text{sh}\alpha ci} \left[ \frac{\text{tg}\alpha ri}{\Omega^L_i}(1 - \cos\alpha ci\,\text{ch}\alpha ci) - 2{,}539 \right.$$

$$\left. (\Omega^L_i - 1)(\sin\alpha ci\,\text{ch}\alpha ci + \cos\alpha ci\,\text{sh}\alpha ci) \right]$$

Fig 3

EP 0 023 162 A1

1

## PERFECTIONNEMENTS AUX FILTRES ELECTROMECANIQUES
## PASSE-BANDE

La présente invention concerne des filtres électromécaniques constitués de barreaux vibrant longitudinalement associés à des coupleurs vibrant en flexion. Ce type de filtre a fait l'objet de nombreuses publications. On citera, entre autres, la demande de certificat d'addition n° 2 389 273 déposée par la Demanderesse le 25 Avril 1977 et les demandes de brevet français n° 2 376 558, 2 389 271 et 79 18 221 déposées par la Demanderesse respectivement les 30 Décembre 1976, 25 Avril 1977 et 13 Juillet 1979.

Le dernier cité de ces documents concerne une cellule unitaire (et les filtres résultant de la mise en série de telles cellules) qui a pour avantage principal de présenter une largeur de bande très voisine de celle de son équivalent électrique, même lorsque la largeur de bande relative atteint une valeur de plusieurs dixièmes.

La présente invention a essentiellement pour objet un filtre électromécanique passe-bande réalisé par mise en cascade de cellules unitaires, dans lequel l'ondulation dans la bande de fréquences transmise est réduite par rapport à la valeur de ladite ondulation obtenue pour les filtres calculés suivant les procédés connus dérivés de la théorie des filtres électriques. Elle s'applique avantageusement aux filtres selon la dernière demande de brevet citée et permet dans ce cas d'obtenir à la fois la largeur de bande désirée, même large, et une caractéristique de transmission particulièrement favorable dans la bande. La mise en oeuvre de l'invention permet, en effet, d'obtenir des filtres dont l'ondulation résiduelle dans une bande relative de 20 % dépasse de 0,02 dB celle du filtre prototype basse fréquence.

La présente invention porte plus particulièrement sur le choix de la largeur de bande de chacune des
cellules élémentaires constituant le filtre mécanique.

L'exposé de l'invention suppose connues les différentes étapes aboutissant à la réalisation d'un filtre
électromécanique. De nombreux articles traitent de ce
sujet ; on citera, à titre d'exemple, l'article publié
par Monsieur BOSC dans le numéro 4, 1964, de la revue
Câbles et Transmission, sous le titre "Aperçus sur la
technique des filtres électromécaniques". D'une façon
très schématique, le réalisateur, à partir des données
(fréquence centrale, largeur de bande, atténuation hors
bande, etc...) définies par un gabarit, réalise la
synthèse d'un filtre électrique. Les résultats de
l'étude du filtre électrique sont ensuite transposés
dans le domaine mécanique par application d'un système
d'équivalence entre grandeurs électriques et grandeurs
mécaniques bien connu de l'homme du métier. Sans entrer
dans le détail de la théorie des filtres, il est utile
de préciser le sens de certains termes qui seront utilisés dans la suite. La théorie des filtres ramène l'étude
du filtre du type désiré (passe-bande polynomial par
exemple) à celle d'un filtre passe-bas dit filtre passe-
bas prototype. Ce filtre prototype est constitué d'une
cascade de cellules du type passe-bas, chacune étant
définie par une fréquence limite maximale au-delà de laquelle la transmission est atténuée. Les cellules électriques de base composant le filtre ayant les caractéristiques désirées s'obtiennent à partir des cellules
du filtre prototype par une transformation mathématique
simple (correspondant à un changement de la variable
liée à la fréquence). Par analogie avec 1ᵗ cellule du
filtre passe-bas prototype, on définit la largeur de
bande d'une cellule de filtre quelconque comme l'in-

tervalle des fréquences transformées des fréquences limitant la bande de la cellule prototype par le changement
de variable mentionné ci-dessus. Dans le cas d'un
filtre complet obtenu par mise en cascade de cellules,
le plus souvent de même type, la réponse dans la bande
passante est définie par le type d'approximation utilisé pour le calcul du filtre (Butterworth, Tschebycheff,
etc...) à partir de la caractéristique d'atténuation de
l'ensemble du filtre. Celle-ci admet pour butée le gabarit à respecter. Cette dernière condition permet de
définir, compte tenu du type d'approximation choisi, le
rapport des impédances des branches des cellules du
filtre passe-bas prototype et grâce à la transformation
de la variable, celui des cellules du filtre électrique
correspondant (passe-bande par exemple). L'équivalence
électromécanique permet alors d'obtenir les grandeurs
caractéristiques du filtre mécanique équivalent.

Ainsi qu'il est bien connu, la théorie des
filtres conduit souvent à des résultats dont la mise en
oeuvre est très complexe et il est d'usage de procéder
à des approximations dans un but de simplification. Ces
approximations se traduisent par l'obtention de caractéristiques réelles qui peuvent présenter un écart
inadmissible par rapport à la caractéristique désirée.

La présente invention consiste en une relation
directe entre l'une des fréquences limites d'une cellule du filtre mécanique et la fréquence limite de la
cellule du filtre passe-bas prototype électrique associée, sans recours à la cellule du filtre électrique de
base, qui permet d'obtenir une caractéristique améliorée
dans la bande transmise, l'amélioration portant sur
l'amplitude des ondulations.

Plus précisément, chaque cellule élémentaire
de rang  i  d'un filtre électromécanique passe-bande
selon l'invention, comportant deux barreaux cylindriques

4

parallèles formant résonateurs vibrant longitudinalement et un coupleur cylindrique vibrant en flexion connecté entre les deux résonateurs, est dimensionnée de telle sorte que l'une des fréquences relatives limites ($\Omega_i^L$) de sa bande de fréquences ($\Omega_i^- - \Omega_i^+$) est liée à la fréquence limite ($f_i^+$) d'une cellule d'un filtre électrique passe-bas dit filtre passe-bas prototype correspondant au filtre électromécanique à réaliser, par la relation :

$$(1) \quad f_i^+ = \frac{A}{\sin\alpha_{ci} + \text{sh}\alpha_{ci}} \left[ \frac{\text{tg}\alpha_{ri}}{\sqrt{\Omega_i^L}} \left(1 - \cos\alpha_{ci}\,\text{ch}\alpha_{ci}\right) - 2,539 \right.$$

$$\left. (\Omega_i^L - 1)(\sin\alpha_{ci}\,\text{ch}\alpha_{ci} + \cos\alpha_{ci}\,\text{sh}\alpha_{ci}) \right]$$

où A est une constante

$$\alpha_{ci} = \frac{3\pi}{4}\sqrt{\Omega_i^L} \cdot \frac{\ell_c}{\ell_o} \quad \text{où} \quad \ell_c \text{ est la longueur du cou-}$$

pleur et $\ell_o$ la longueur du coupleur correspondant à un effet quart d'onde à la fréquence centrale de la bande de fréquences à transmettre par le filtre électromécanique.

$$\alpha_{ri} = 2\pi n_r \Omega_i^L m \quad \text{où} \quad m \text{ est l'ordre du mode de vi-}$$

bration et où $n_r = \frac{\ell_r}{\lambda_o}$ avec $\ell_r$ la longueur des résona-teurs et $\lambda_o$ la longueur d'onde à la fréquence fondamentale d'accord des résonateurs en vibration longitudinale.

Les filtres les plus couramment réalisés comportent des coupleurs quart d'onde, d'où $\ell_c = \ell_o$ et des résonateurs demi-onde vibrant selon le mode fondamental $n_r = \frac{1}{2}$ et m = 1.

on a donc :

$$\alpha_{ci} = \frac{3\pi}{4}\sqrt{\Omega_i^L}$$

et $\alpha_{ri} = \pi\Omega_i^L$

5

L'expérience a montré que, dans le cas de caractéristiques symétriques, il est préférable d'employer comme fréquence relative limite de la bande de fréquences $(\Omega_i^- - \Omega_i^+)$ de la cellule de rang i , la fréquence relative inférieure $\Omega_i^-$ de cette bande.

D'autres caractéristiques et avantages de l'invention apparaîtront mieux dans la description détaillée qui suit et se réfère aux dessins annexés donnés uniquement à titre d'exemple et dans lesquels :

- les figures 1 et 2 représentent la définition de certaines grandeurs utilisées par la suite ;

- la figure 3 est une représentation schématique d'un exemple de filtre selon l'invention ;

- les figures 4 représentent un ensemble de courbes permettant de comparer la caractéristique d'atténuation du filtre de la figure 3 avec celle d'un filtre selon l'art antérieur.

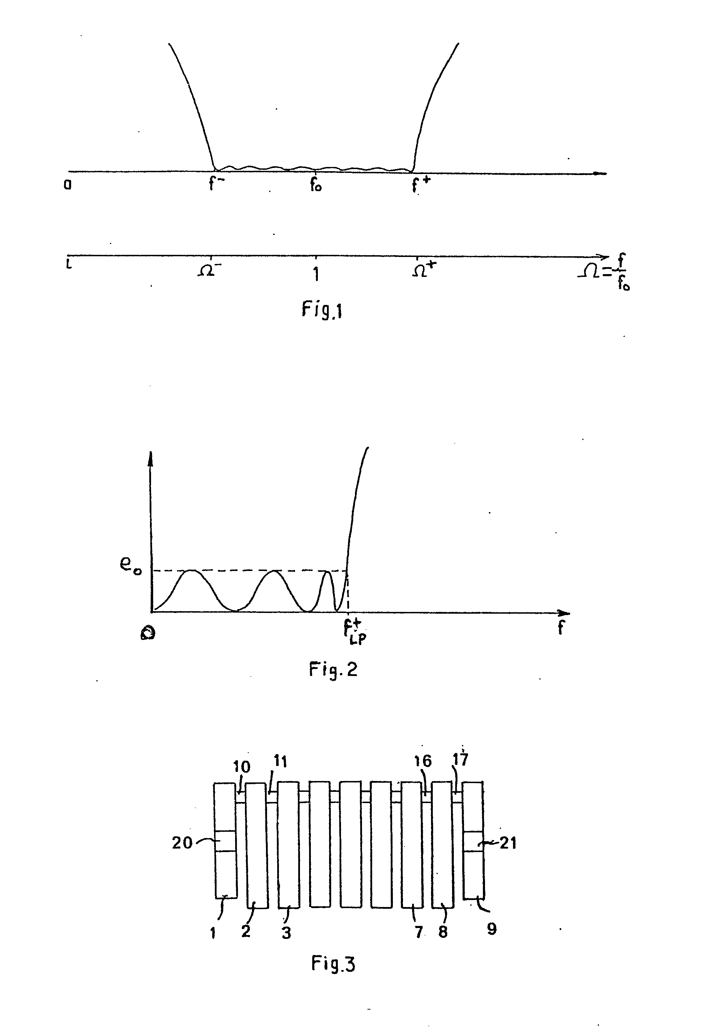

La figure 1 représente respectivement en a) et b) l'axe des fréquences f et celui des fréquences relatives $\Omega = f/f_0$ , $f_0$ étant la fréquence centrale du filtre qui doit transmettre les fréquences situées entre $f^-$ et $f^+$ et atténuer les autres fréquences, ainsi qu'il est figuré par l'esquisse de la courbe d'atténuation de la figure 1a. $\Omega^-$ correspond à la valeur relative de la limite inférieure $(f^-/f_0)$ de la bande passante et $\Omega^+$ correspond à la valeur relative de la limite supérieure $(f^+/f_0)$ de la bande passante.

La figure 2 représente la réponse amplitude-fréquence d'un filtre passe-bas, tel le filtre passe-bas prototype du filtre mécanique à réaliser. Dans l'approximation de Tschebycheff, la fréquence limite supérieure $f_{LP}^+$ du filtre passe-bas prototype est définie par l'intersection de la caractéristique d'atténuation et de la parallèle à l'axe des abscisses qui passe par le sommet des ondulations de ladite courbe dans la bande, cette approximation consistant à les choisir d'amplitude égale dans la bande. Cette amplitude est représentée par $e_o$. La définition de $f_{LP}^+$ est liée au type d'approximation choisi ainsi qu'il est connu de l'homme du métier. Il est connu, comme le décrit l'ouvrage écrit par Messieurs TEMES et MITRA, intitulé : "Modern filter theory and design" page 23 de l'édition de 1973 chez John WILEY, que la caractéristique d'atténuation d'une cellule du filtre passe-bande électrique correspondant au filtre passe-bas prototype est donnée par la même fonction d'une nouvelle variable définie par

$$\omega_{LP} = A \frac{\omega_2^2 - \omega^2}{-\omega} \qquad \text{où } \omega_{LP} \text{ est la pulsation}$$

de la cellule du filtre passe-bas prototype,

A est une constante positive, $\omega_2$ est la pulsation de la fréquence centrale du filtre passe-bande et $\omega$ est la pulsation du filtre passe-bande correspondant. D'autres changements de variable permettent de passer du filtre prototype à tout autre type de filtre électrique désiré selon l'art antérieur. Une fois les caractéristiques des cellules du filtre passe-bande électrique désiré obtenues, le recours à un système d'équivalence permet d'obtenir les grandeurs caractéristiques des cellules du filtre électromécanique.

La présente invention a essentiellement pour caractéristique des filtres électromécaniques passe-bande dont chacun est dérivé d'un filtre électrique passe-bas prototype constitué par une mise en cascade de cellules, dont les bandes passantes individuelles sont définies par une approximation choisie parmi celles connues de l'homme du métier, dans lesquels les cellules du filtre mécanique correspondent aux cellules du filtre électrique passe-bas prototype, de façon que la condition

$$f_i^+ = A \gamma(\Omega_i^L) \text{ soit remplie}$$

où $f_i^+$ est la fréquence limite de la cellule de rang i du filtre électrique passe-bas prototype,

$\Omega_i^L$ est une fréquence relative limite de la bande passante de la cellule de rang i du filtre mécanique (de préférence la fréquence limite inférieure),

et la fonction $\gamma$ est définie par

$$\gamma(\Omega_i^L) = \frac{1}{\sin\alpha_{ci} + \sh\alpha_{ci}}\left[\frac{\tg\alpha_{ri}}{\sqrt{\Omega_i^L}}(1-\cos\alpha_{ci}\ch\alpha_{ci}) - 2,539\right.$$
$$\left.(\Omega_i^L - 1)(\sin\alpha_{ci}\ch\alpha_{ci} + \cos\alpha_{ci}\sh\alpha_{ci})\right]$$

où $\alpha_{ri} = \pi\Omega_i^L$ pour un résonateur demi-onde à vibration longitudinale

$\alpha_{ci} = \frac{3\pi}{4}\sqrt{\Omega_i^L}$ pour un coupleur quart d'onde à vibration en flexion

A est une constante dont la valeur est :

(2)    $A = \dfrac{f_{LP}^+}{\gamma(\Omega^L)}$

où $\Omega^L = f^L/f_o$ est une fréquence relative limite de la bande transmise par le filtre mécanique, telle qu'il est montré sur la figure 1b, et de préférence la fréquence relative inférieure, soit $\Omega^- = f^-/f_o$ .

$f_{LP}^+$ est la fréquence limite de la bande transmise par le filtre électrique passe-bas prototype, telle qu'il est montré sur la figure 2.

La figure 3 représente schématiquement un filtre électromécanique passe-bande comportant neuf barreaux cylindriques parallèles formant résonateurs (1 à 9) vibrant longitudinalement, et réunis entre-eux par huit coupleurs cylindriques (10 à 17) vibrant en flexion. Les résonateurs extrêmes 1 et 9 portent respectivement des transducteurs électromécaniques réversibles 20 et 21 connectés aux bornes d'entrée et de sortie du filtre, non représentées.

La Demanderesse a réalisé deux filtres du type représenté sur la figure 3 ayant une bande passante relative de 20 % et une fréquence centrale de 100 KHz selon l'approximation de Tschebycheff.

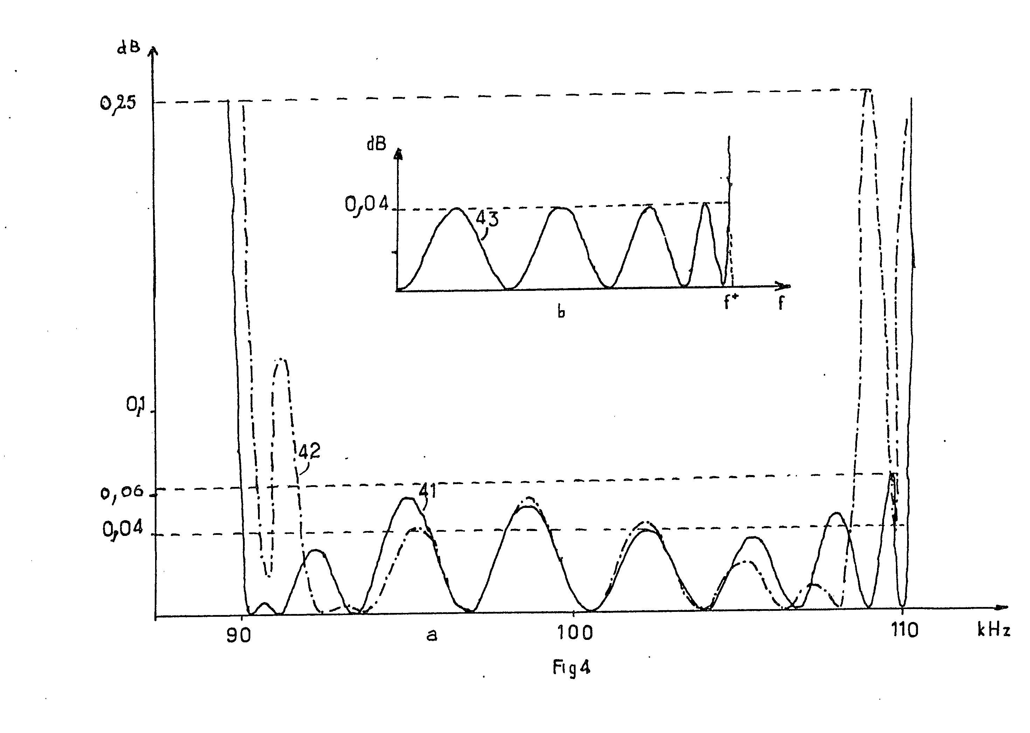

Le premier, dont la caractéristique est représentée par la courbe 42 de la figure 4a, est une mise en oeuvre de la demande de brevet enregistrée sous le numéro 79 18 221 déposée le 13 Juillet 1979 par la Demanderesse. Il est composé de neuf résonateurs constitués de barreaux d'élinvar identiques (diamètre 3,5 mm, longueur 24 mm) vibrant longitudinalement sous l'action de transducteurs constitués de céramiques piézoélectriques de 2,5 mm de diamètre, 3 mm d'épaisseur et de 19 mm de longueur. Les résonateurs sont couplés par des coupleurs, de même matériau, de longueur identique (1,10 mm) dont les diamètres, différents, sont compris entre 1,38 et 1,42 mm.

Le second, dont la caractéristique est la courbe 41 de la figure $4_a$ , a été réalisé par mise en oeuvre de la présente invention. Les transducteurs sont identiques. Le matériau constituant les deux filtres également. Les résonateurs sont des barreaux de 24 mm de long dont le diamètre est compris entre 3,50 mm et 3,55 mm ; les coupleurs sont en élinvar, ils ont une longueur de 1,10 mm et un diamètre compris entre 1,40 mm et 1,44 mm.

La comparaison des courbes 41 et 42 montre que les ondulations de grande amplitude de la courbe 42 situées aux extrémités de la bande transmise, ont disparu sur la courbe 41 du filtre selon l'invention. On constate que l'amplitude maximale des ondulations de la courbe 41 est de 0,06 dB. On a, pour servir de repère, représenté par la courbe 43 de la figure 4b la caractéristique de transmission du filtre passe-bas élec-

trique prototype utilisé à la conception des deux filtres comparés. On constate que l'amplitude commune des
ondulations est de 0,04 dB, c'est-à-dire très voisine de
l'amplitude moyenne des ondulations de la courbe 41 qui
restent comprises entre 0,03 et 0,062 dB, alors que
celles de la courbe 42 atteignent 0,25 dB.

La détermination d'un filtre mécanique selon
l'invention est effectuée de la manière suivante :

La réponse en fréquence du filtre mécanique à
réaliser est définie par les données $f_o$ , $f^-$ (figure 1a);
d'où $\Omega^- = f^-/f_o$ (figure 1b) et, dans le cas de l'approximation de Tschebycheff, par l'ondulation dans la
bande passante ($e_o$ de la figure 2). Si une autre approximation est choisie, une autre forme de courbe est
obtenue.

Le degré d du filtre (nombre de cellules) est
fixé en fonction des caractéristiques recherchées en
bande atténuée comme il est connu de l'homme du métier.

La synthèse du filtre électrique passe-bas prototype de degré d , d'ondulation $e_o$ et de fréquence limite de bande $f_{LP}^+$ est effectuée en application des
méthodes connues.

La constante A est calculée par la formule (2).

La formule (1) permet de déterminer les fréquences relatives limites, et de préférence la fréquence relative inférieure $\Omega_i^-$ de la bande passante de
chacune des cellules du filtre mécanique passe-bande à
partir de la fréquence maximale $f_i^+$ de chacune des
cellules du filtre électrique passe-bas prototype par
calcul de la relation inverse. La définition des cellules élémentaires du filtre mécanique est limitée à
une condition (fréquence limite inférieure). D'autres
conditions (matériau unique, longueur unique de l'un
des éléments) se traduisent par la définition de certains paramètres des éléments : coupleurs et résonateurs, les autres étant choisis par le fabricant.

Selon une variante préférée, on utilise à la définition du rapport des diamètres des résonateurs et des coupleurs la relation faisant l'objet de la demande de brevet français déposée le 13 Juillet 1979 sous le numéro 79 18 221 par la Demanderesse, permettant d'obtenir une optimisation de la largeur de bande de chaque cellule. Cette relation est la suivante, dans le cas le plus fréquent de résonateurs demi-onde et de coupleur quart d'onde, et où $x_i$ est le coefficient de couplage de la cellule de rang $i$ :

$$x_i = \frac{\mathrm{tg}\,\pi\overline{\Omega_i}}{\sqrt{\overline{\Omega_i}}} \cdot \frac{1 - \cos\overline{\alpha_i}\,\mathrm{ch}\overline{\alpha_i}}{\sin\overline{\alpha_i}\,\mathrm{sh}\overline{\alpha_i} + \cos\overline{\alpha_i}\,\mathrm{ch}\overline{\alpha_i} + \sin\overline{\alpha_i} + \mathrm{sh}\overline{\alpha_i}}$$

$$\text{où } \overline{\alpha_i} = \frac{3\pi}{4}\sqrt{\overline{\Omega_i}}$$

Cette relation permet de déterminer le diamètre du coupleur en fonction du diamètre des résonateurs pour chaque cellule.

11

REVENDICATIONS

1 - Filtre électromécanique passe-bande comportant une pluralité de cellules en cascade, chaque cellule comportant :

- deux barreaux cylindriques parallèles formant résonateurs (2, 3) vibrant longitudinalement ; et

- un coupleur cylindrique (11) vibrant en flexion, connecté entre les deux résonateurs ; caractérisé en ce que la cellule de rang $i$ est dimensionnée de telle sorte que l'une des fréquences relatives limites $(\Omega_i^L)$ de sa bande de fréquences $(\Omega_i^- - \Omega_i^+)$ est liée à la fréquence limite $(f_i^+)$ d'une cellule pour un filtre électrique passe-bas correspondant au filtre électromécanique à réaliser, par la relation :

$$f_i^+ = \frac{A}{\sin\alpha_{ci} + \text{sh}\alpha_{ci}} \left[ \frac{\text{tg}\alpha_{ri}}{\sqrt{\Omega_i^L}} (1 - \cos\alpha_{ci}\,\text{ch}\alpha_{ci}) - 2{,}539 \right.$$
$$\left. (\Omega_i^L - 1)(\sin\alpha_{ci}\,\text{ch}\alpha_{ci} + \cos\alpha_{ci}\,\text{sh}\alpha_{ci}) \right]$$

où :

A est une constante

$\alpha_{ci} = \frac{3\pi}{4}\sqrt{\Omega_i^L} \cdot \frac{\ell_c}{\ell_o}$ où $\ell_c$ est la longueur du coupleur et $\ell_o$ la longueur du coupleur correspondant à un effet quart d'onde à la fréquence centrale de la bande de fréquences à transmettre par le filtre électromécanique

$\alpha_{ri} = 2\pi n_r \Omega_i^L m$ où m est l'ordre du mode de vibration des résonateurs et où $n_r = \frac{\ell_r}{\lambda_o}$ avec $\ell_r$ la longueur des résonateurs et $\lambda_o$ la longueur d'onde à la fréquence fondamentale d'accord des résonateurs en vibration longitudinale.

2 - Filtre électromécanique selon la revendication 1, caractérisé en ce que la fréquence relative limite $(\Omega_i^L)$ est la fréquence relative inférieure $(\Omega_i^-)$

12

de la bande de fréquences de la cellule de rang i.

3 - Filtre électromécanique selon l'une des revendications 1 et 2, caractérisé en ce que les résonateurs sont demi-onde et le coupleur quart d'onde.

4 - Filtre électromécanique selon l'une des revendications précédentes, caractérisé en ce qu'il comporte des transducteurs électromécaniques d'entrée (20) et de sortie (21) associés aux cellules en cascade.

1/2　　　　0023162

Fig.1

Fig. 2

Fig.3

Fig 4

0023162

0023162

Numéro de la demande

EP 80 40 0909

**Office européen des brevets**

**RAPPORT DE RECHERCHE EUROPEENNE**

| Catégorie | Citation du document avec indication, en cas de besoin, des parties pertinentes | Revendication concernée |
|---|---|---|
| | **DOCUMENTS CONSIDERES COMME PERTINENTS** | |
| DA | FR - A - 2 376 558 (LTT) <br> * En entier * | 1,3,4 |
| | -- | |
| DA | FR - A - 2 389 271 (LTT) <br> * En entier * | 1,3,4 |
| | -- | |
| DA | FR - A - 2 389 273 (LTT) <br> * En entier * | 1,3,4 |
| | ---- | |

**CLASSEMENT DE LA DEMANDE (Int. Cl. 3)**

H 03 H 9/50

**DOMAINES TECHNIQUES RECHERCHES (Int. Cl. 3)**

H 03 H 9

**CATEGORIE DES DOCUMENTS CITES**

X: particulièrement pertinent
A: arrière-plan technologique
O: divulgation non-écrite
P: document intercalaire
T: théorie ou principe à la base de l'invention
É: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 30-09-1980 | DECONINCK |

OEB Form 1503.1   06.78